# EUROPEAN PATENT APPLICATION

(11) **EP 2 199 665 A1**
(43) Date of publication of application: **23.06.2010**
(21) Application number: 09176945.5
(22) Date of filing: 24.11.2009
(51) Int. Cl.: F21V 19/00, H05K 1/14, H05K 3/30, H01L 33/48

(54) **Method and apparatus for flexible mounting of light emitting devices**

(30) Priority: 16.12.2008 US 335631
(71) Applicant: CREE, INC., Durham, NC 27703 (US)
(72) Inventor: Villard, Russell G., Apex, NC 27502 (US); Higley, Robert Edward, Cary, NC 27519 (US)
(74) Representative: Schickedanz, Willi

(57) **Abstract**

LED mounting arrangements are described which provide flexibility for LED users to mount a first LED having different physical, electrical, thermal, or other characteristic footprints from those for a second LED on a mounting pad designed for the second LED. With such arrangements, migration from one LED to another can be facilitated without the need for redesigning the printed circuit board for a lighting application. Flexibility is thereby provided to LED customers.

## Description

### Field of the Invention

The present invention relates generally to improvements in the field of mounting arrangements for light emitting devices, and, in particular, to methods and apparatus for improving the flexibility of light emitting device mounting arrangements.

### Background of the Invention

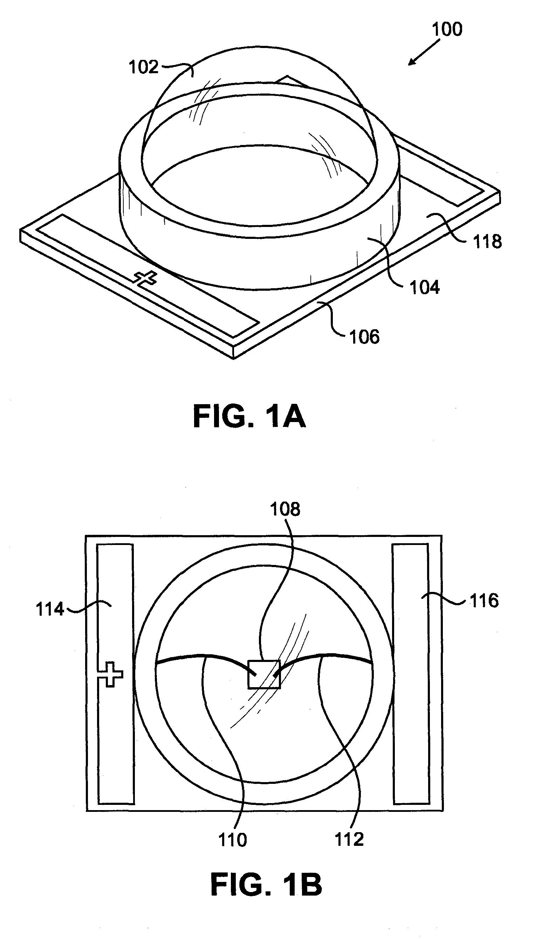

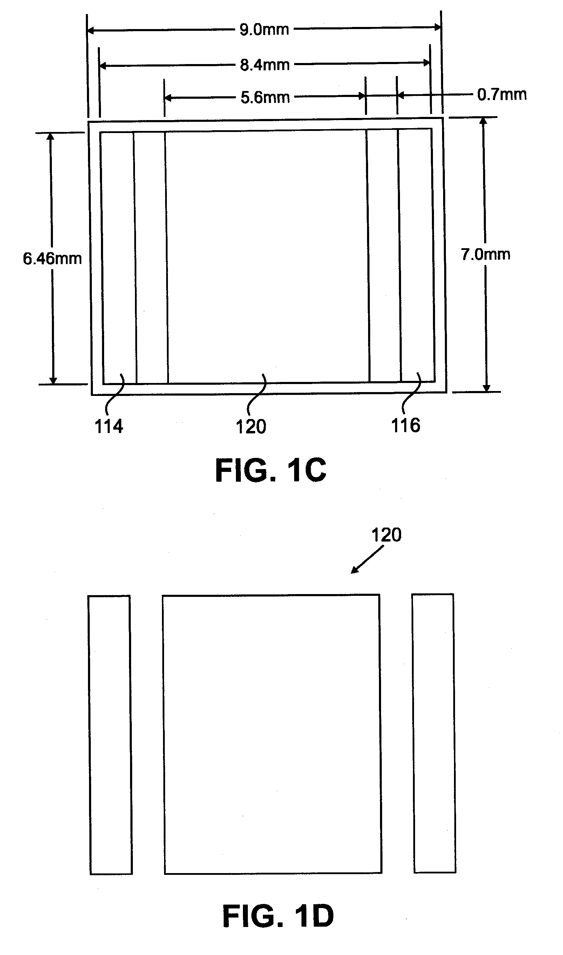

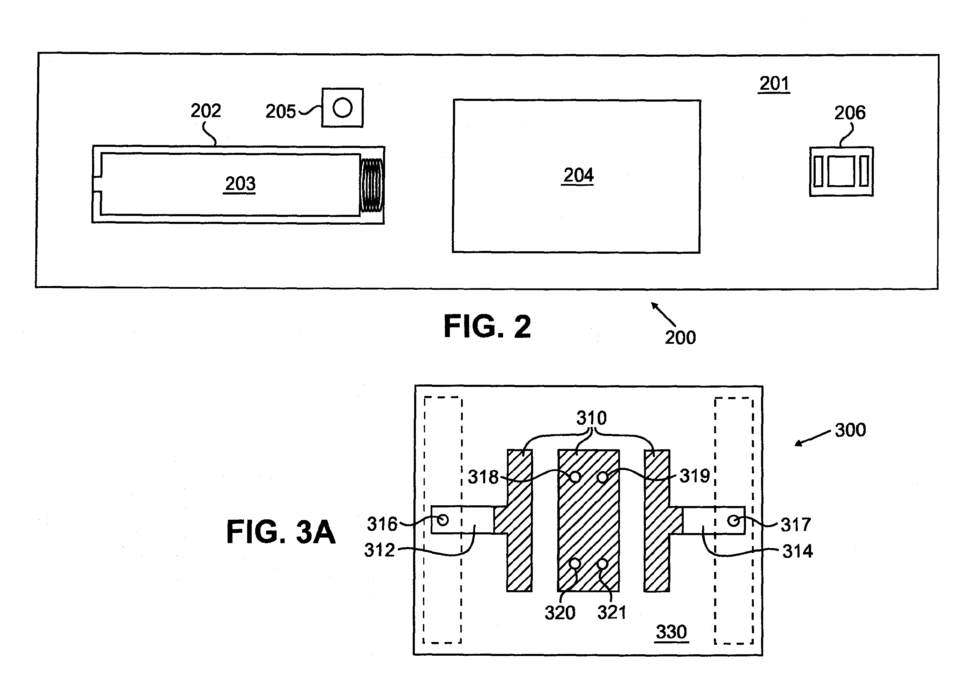

Figs. 1A, 1B, 1C and 1D illustrate a standard LED packaging arrangement, such as that employed by the XLamp® 7090 XR-E series of LED products manufactured by Cree, Incorporated, and how that packaged LED lamp may be suitable mounted on a larger printed circuit board (PCB). As seen in Fig. 1A, a packaged LED lamp 100 comprises a lens 102, a reflector 104 and a mounting substrate 106. The arrangement 100 may also be referred to as an LED, LED lamp or a lamp. As seen in Fig. 1B, an LED chip 108 is electrically connected by bond wires 110 and 112 to electrical contact strips 114 and 116, respectively, on the substrate 106 which may suitably be a printed circuit board (PCB), such as a flame resistant 4 (FR4) board. When power is applied through the contacts 114 and 116, chip 108 emits light. The chip 108 is shown as having two top contacts for a chip having a horizontal arrangement. However, alternative LED chips and chip mounting arrangements are possible where the LED has a horizontal or vertical orientation or is flip chip mounted, as would be understood by one of ordinary skill in the art. In the arrangement shown, reflector 104 helps direct the emitted light upwards and the lens 102 focuses the emitted light. The chip 108 is thermally mounted on top surface 118 of substrate 106 with a thermal bonding paste. Fig. 1C shows a bottom surface 120 of the substrate 110 and electrical contacts 114 and 116 along with representative dimensions for the XLamp® 7090 XR-E series of LED products. It will be recognized that 9.0 mm is slightly smaller than 1 cm and is about 1/3 of an inch. As a result, it can be seen that the XLamp® LED products and other similar products have a small form factor compared to typical incandescent bulbs. Fig. 1D shows a solder pad 120 for mounting the packaged LED lamp 100 to a larger PCB, such as the one shown in Fig. 2.

Fig. 2 shows a PCB 201 for an LED flashlight demonstrator 200. The PCB 201 on its top surface has a battery mount 202 with a battery 203, circuitry 204, a push button on/off switch 205 and an LED solder mounting pad 206 corresponding to the pad 120 of Fig. 1D. Electrical connections of the various components on the top surface of PCB 201 are made by electrical traces on the bottom surface of PCB 201 in a known fashion. In a typical approach to manufacturing a product, such as a flashlight employing an LED, a customer designs a printed circuit board, such as board 201, for an LED from a particular manufacturer. The LED customer having procured an inventory of such boards will be locked in to selecting an LED having contacts which can be mounted on the mounting pad on the board, such as pad 206, shown in Fig. 2. If that customer wants to switch to a different LED having a different contact arrangement, then that customer has to wait until the inventory of PCBs is used up or bear the cost of disposing of the remaining boards, redesigning a new board compatible with the new LED, and the cost of obtaining the new boards, or the like.

### Summary of the Invention

Among its several aspects, the present invention recognizes that more flexible and cost effective mounting arrangements are desirable to address such problems, as well as others. For example, hobbyists may want to try different LEDs. A large scale manufacturer may know that a better LED will become available from the LED supplier within the next six months. For example, a production schedule may be in place for a smaller, brighter LED that uses less power. In such a case, the manufacturer may not want to be locked in to the older LED until an existing inventory of PCBs is used up, or may want to have the flexibility of using the older proven LED until a new LED has successfully passed beta testing.

To such ends, the present invention provides a low cost and flexible mounting arrangement which provides a migration path for a coming upgrade. This arrangement can also be employed to support side by side testing of competitive LEDs and the needs of hobbyists and others desiring greater flexibility as discussed in greater detail below.

One aspect of the present invention addresses a footprint adapter or converter for light emitting devices, such as LEDs and the like. The adapter may be suitably embodied on a flame resistant (FR) 4 board which allows a second light emitting device with a different physical, different thermal, different electrical, or some other different characteristics, or a combination of different footprint characteristics to be used in place of a first light emitting device at relatively low cost as addressed further below. Thus, for example, an existing PCB can be retrofit with a new and different LED.

In another aspect, a light emitting device footprint adapter is provided comprising a mounting substrate having a top surface with first mounting contacts for mounting a first light emitting device; the substrate having a bottom surface with mounting contacts for mounting the substrate on a mounting surface having second mounting contacts for a second light emitting device having a different footprint than the first light emitting device; and connections through the mounting substrate connecting the first mounting contacts of the top surface with the second mounting contacts of the bottom surface.

In another aspect, a method is provided for utilizing a light emitting device footprint adapter to enable replacement of a first light emitting device having a mounting arrangement with a second light emitting device having an incompatible mounting arrangement. The method may suitably comprise mounting the second light emitting device on a top mounting surface of an adapter, the top mounting surface having mounting contacts for mounting the second light emitting deice, the adapter having a bottom mounting surface with compatible mounting contacts for mounting the adapter on the mounting pad for the first device; mounting the bottom mounting surface of the adapter on the mounting pad for the first light emitting device; and connecting the mounting contacts for mounting the second light emitting device to the compatible mounting contacts for mounting the adapter through the adapter.

These and other advantages and aspects of the present invention will be apparent from the drawings and Detailed Description which follow.

### Brief Description of the Drawings

Figs. 1A, 1B and 1C show a top perspective, a top, and a bottom view, respectively, of a typical prior art mounting arrangement for mounting an LED on a flame resistant (FR) 4 board; and Fig. 1D shows a printed circuit board (PCB) solder pad for mounting the LED lamp package of Figs. 1A-1C to a larger PCB board for a particular application;
Fig. 2 shows an example of a PCB board for a flashlight application demonstrator employing the solder pad of Fig. 1D;
Figs. 3A and 3B show an example of a footprint adapter in accordance with the present invention for mounting a Cree® XLamp® XP-E LED on a printed circuit board with a solder pad for a Cree® XLamp® XR-E LED;
Figs. 4A, 4B and 4C show examples of footprint adapters in accordance with the present invention for mounting a Cree® XLamp® MC-E LED on a printed circuit board with a solder pad for the XR-E LED;
Figs. 5A, 5B and 5C illustrate a perspective and bottom view of a Luxeon® Rebel LED, and Fig. 5C shows a footprint adapter in accordance with the present invention for mounting the Rebel LED on an XR-E LED solder pad;
Fig. 6 shows a top view of a footprint adapter in accordance with the present invention for mounting a Nichia® NS6 LED on an XR-E LED solder pad;
Figs. 7A and 7B show top and bottom views of a footprint adapter in accordance with the present invention for mounting a Luxeon® K2 LED on a XR-E LED solder pad;
Figs. 8A-8C illustrate further footprint adapters in accordance with the present invention; and
Fig. 9 shows a process of using a footprint adapter in accordance with the present invention.

### Detailed Description

Where an LED lamp or some other type of light emitting device is to be replaced by another having the same physical dimensions, the same electrical contact pattern, and similar thermal characteristics, no mounting issues may be presented. However, where a smaller or larger physical device is present, a different electrical contact or driving arrangement, and different thermal dissipation requirements, all three, or some combination thereof are presented, the present invention recognizes that end users having committed to a particular printed circuit board (PCB) need an alternative to using up the boards with less efficient or effective LEDs or junking an existing inventory of PCBs.

Such a circumstance can arise even with a single LED supplier, such as Cree Incorporated which recently announced Cree® XLamp® XP-E LEOs in a package with an 80% smaller physical size than the Cree® XLamp® XR-E LED. Additionally, the Cree® XLamp® MC-E LED while having a similar physical size to the XR-E LED has a very different electrical contact arrangement as will be discussed further below. With multiple LED suppliers in the mix, the variety of physical sizes, electrical contact arrangements, thermal dissipation requirements, and the like can be large. Among its several aspects, the present invention addresses cost effective techniques for customer migration from one LED to another consistent with the different physical, electrical and thermal footprints of these various devices.

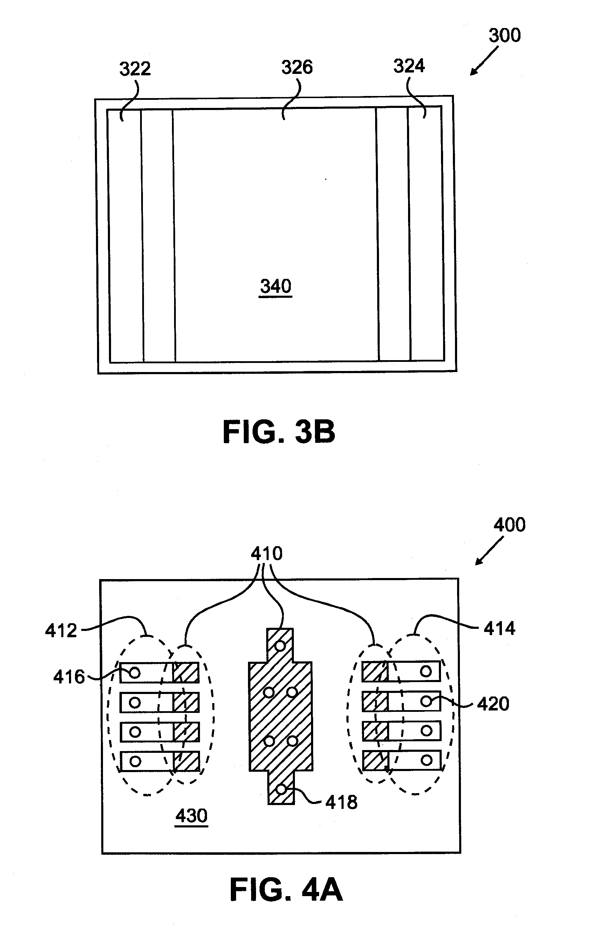

To such ends, Figs. 3A and 3B show a top and bottom view, respectively, of a physical size, electrical, and thermal footprint adapter 300 according to the present invention which supports the migration of a manufacturer from the XR-E lamp of Fig. 1A to the XP-E lamp as discussed further below. In one embodiment, the footprint adapter 300 may be suitably embodied using an FR 4 board as a mounting substrate as discussed further below. In this embodiment, the physical dimensions of board 300 correspond to those shown in Fig. 1C. As shown in Fig. 3A, the top of board 300 has a standard solder pad cross-hatched portion 310 for the XP-E lamp modified to include extending arm portions 312 and 314. The bottom of board 300 shown in Fig. 3B has the standard electrical and thermal contacts 322, 324 and 326, respectively for the XR-E lamp. These contacts correspond to those shown in Fig. 1C. In addition to standard solder pad 310 and extended arm portions 312 and 314, there are a number of vias or holes 316-321 drilled through the FR4 board 300. These vias allow solder to flow from top surface 330 to bottom surface 340 so that electrical and thermal contact are made through the adapter as follows. Via 316 when filled with solder makes electrical contact between extended arm 312 and electrical contact 322. Similarly, via 317 makes electrical contact between extended arm 314 and electrical contact. Vias 318-321 make thermal contact between central thermal portion of solder pad 310 and thermal pad 326. While Fig. 3A shows an exemplary solder pad and via arrangement, it will be recognized that other arrangements may be devised consistent with the present teachings and the electrical and thermal connections desired for a particular application.

As one example of the use of footprint adapter 300, if a manufacturer of LED flashlights has been using boards like board 200 with the XR-E lamp and wants to retrofit those boards with the XP-E lamp which has an 80% smaller package footprint, the footprint adapter 300 allows that manufacturer to do so. Footprint adapter 300 adapts for the smaller physical size and the different electrical and thermal mounting characteristics comprising the different footprint of the XP-E.

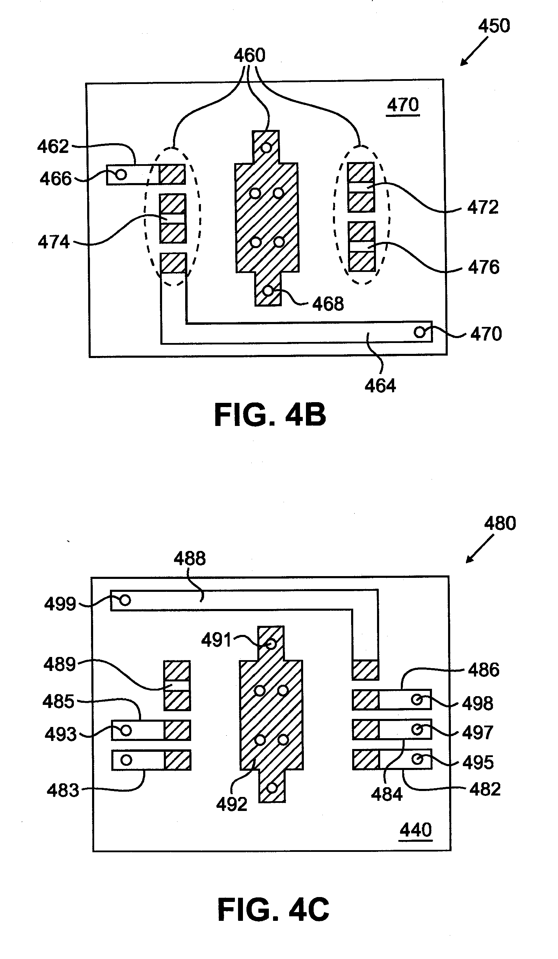

Figs. 4A, 4B and 4C show top views of electrical and thermal footprint adapters 400, 450 and 480 according to the present invention which support the migration of a manufacturer from the XR-E lamp of Fig. 1A to the MC-E lamp as discussed further below. Bottom views are not shown as they correspond to that seen in Fig. 3B. With the addition of appropriate active electrical drive circuitry if necessary, the availability of the adapters 400, 450 and 480 gives a manufacturer the ability to utilize an XR-E lamp for one application (no adapter), the MC-E lamp wired for parallel operation for another application (adapter 400), the MC-E lamp wired for series operation for a third application (adapter 450) and the MC-E lamp wired for two chips in series and two chips in parallel (adapter 480).

The physical dimensions of adapters 400, 450 and 480 correspond to those shown in Fig. 1C. As shown in Fig. 4A, the top of adapter 400 has a standard solder pad cross-hatched portion 410 for the MC-E lamp. The MC-E lamp has four LED chips with a pair of contacts for each. In Fig. 4A, the standard solder pad has been modified to include extending arm portions 412 and 414. The bottom of the adapter 400 not shown has the same standard electrical and thermal contacts for the XR-E lamp, like contacts 322, 324, and 326 shown in Fig. 3B. In addition to standard solder pad 410 and extended arm portions 412 and 414, there are a number of vias or holes, such as vias 416, 418 and 420 drilled through the adapter 400 which may be embodied in an FR4 board as discussed above. These vias allow solder to flow from top surface 430 to the bottom surface so that electrical and thermal contacts are made as follows. Via 412 when filled with solder makes electrical contact between its corresponding arm 412 and an electrical contact, like contact 322, on the bottom of adapter 400. Similarly, via 420 makes electrical contact between its corresponding arm 414 and an electrical contact, like contact 324, on the bottom of adapter 400. Vias, such as via 418, make thermal contact between central thermal portion of solder pad 410 and a thermal pad, like pad 326, on the bottom of adapter 400.

As shown in Fig. 4B, the top 470 of adapter 450 has a standard solder pad cross-hatched portion 460 for the MC-E lamp modified to include extending arm portions 462 and 464, as well as, contact connectors 472, 474 and 476 to support serial operation. The bottom of adapter 450 not shown has standard electrical and thermal contacts such as the contacts 322, 324 and 326 shown in Fig. 3B for the XR-E lamp. In addition to the standard solder pad 460, the extended arm portions 462 and 464, and the contact connectors 472, 474 and 476, there are a number of vias or holes, such as vias 466, 468 and 470, drilled through the adapter 450 which may be embodied as an FR4 board as discussed herein. These vias allow solder to flow from top surface 470 to bottom surface like surface 340 so that electrical and thermal connections through adapter 450 contact are made as follows. Via 466 when filled with solder makes electrical contact between arm 462 and an electrical contact, such as contact 322 of Fig. 3B. Similarly, via 470 makes electrical contact between arm 464 and a corresponding electrical contact like contact 324. Via 468 makes thermal contact between central thermal portion of solder pad 460 and a thermal pad like pad 326.

As shown in Fig. 4C, the top 490 of adapter 480 has a standard solder pad cross-hatched portion for the MC-E lamp modified to include extending arm portions 482, 483, 484 and 485 supporting parallel operation of to chips of the MC-E lamp. Extending arm portions 486 and 488, as well as contact connector 489, support serial operation of the other two chips of the MCE-lamp. The bottom of adapter 480 not shown has standard electrical and thermal contacts such as the contacts 322, 324 and 326 shown in Fig. 3B for the XR-E lamp. In addition to the standard solder pad 492, the extended arm portions and the contact connector, there are a number of vias or holes, such as vias 491, 493, 494, 495, 496, 497, 498 and 499, drilled through the adapter 480 which may be embodied as an FR4 board as discussed herein. These vias allow solder to flow from top surface 490 to bottom surface like surface 340 so that electrical and thermal connections through adapter 480 contact are made.

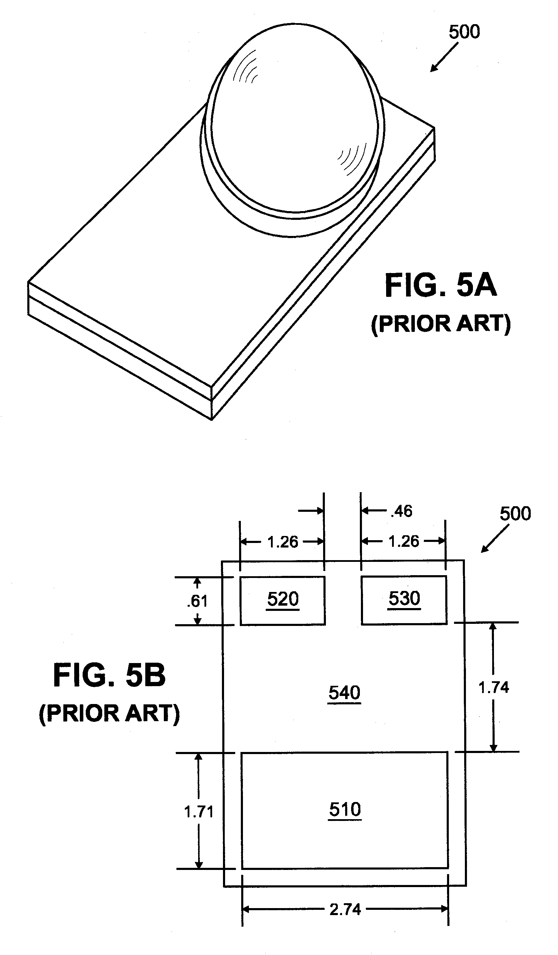

Figs. 5A and 5B illustrate a perspective view and bottom view of a prior art Luxeon® Rebel LED 500, respectively. As seen in Fig. 5B, a thermal pad 510 and two electrical contact pads 520 and 530 are found on the bottom of an adapter 540. Exemplary dimensions in millimeters for the pads 510, 520 and 530 are shown in Fig. 5B. By comparing these dimensions with those seen in Fig. 1C, it is seen that the LED 500 is physically, electrically and thermally incompatible with the standard mounting pad seen in Fig. 1D.

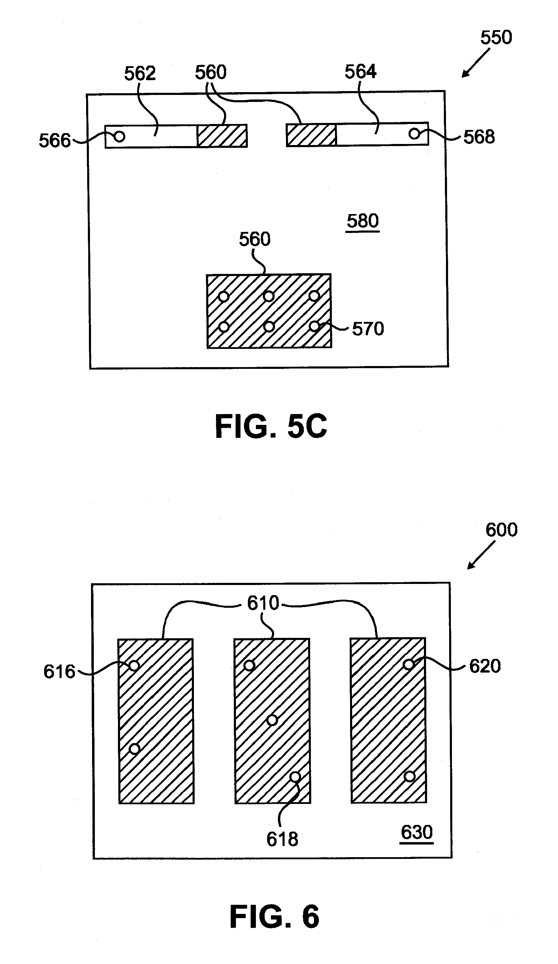

Fig. 5C shows a top view of a footprint adapter 550 according to the present invention which allows a customer to mount a Rebel LED 500 on a PCB, such as the PCB 200 of Fig. 2 having a solder pad for an XR-E LED, such as LED 100. As seen in Fig. 5C, the top of adapter 550 has a standard Rebel solder pad 560 which has been modified to include additional extended arm portions 562 and 563 which are shown cross hatched. A number of vias, such as vias 566, 568 and 570 allow solder to flow from top surface 580 of adapter 550 to electrical and thermal contacts as discussed further below. Via 566 connects extended arm 566 and its respective contact to an electrical contact, like contact 322 of Fig. 3B, on the bottom of adapter 550. Via 568 connects extended arm 568 and its respective contact to an electrical contact, like contact 324 of Fig. 3B, on the bottom of adapter 550. Via 570 connects the thermal pad, like pad 326 of Fig. 3B, on the bottom of adapter 550.

Fig. 6 shows a top view of an adapter 600 according to the present invention which supports the migration of a manufacturer from the XR-E lamp of Fig. 1A to a Nichia® NS6 lamp as discussed further below. The physical dimensions of board 600 correspond to those shown in Fig. 1C. As shown in Fig. 6, the top of adapter 600 has a standard solder pad cross-hatched portion 610 for the NS6 lamp. The bottom of adapter 600 has standard electrical and thermal contacts like the contacts 322, 324 and 326 of Fig. 3B for the XR-E lamp. In addition to standard solder pad 610, there are a number of vias or holes, such as vias 616, 618, 620 drilled through the adapter 600. These vias allow solder to flow from top surface 630 to the bottom surface so that electrical and thermal contact are made as follows. Via 616 when filled with solder makes electrical contact between its corresponding electrical contact and an electrical contact, like contact 322 of Fig. 3B. Similarly, via 618 makes electrical contact between its corresponding electrical contact and an electrical contact like electrical contact 324. Vias, such as via 618 make thermal contact between the corresponding thermal portion of solder pad 610 and a thermal pad, like thermal pad 326. While Fig. 6 shows an exemplary solder pad and via arrangement, it will be recognized that other arrangements may be devised consistent with the present teachings and the electrical and thermal connections desired for a particular application.

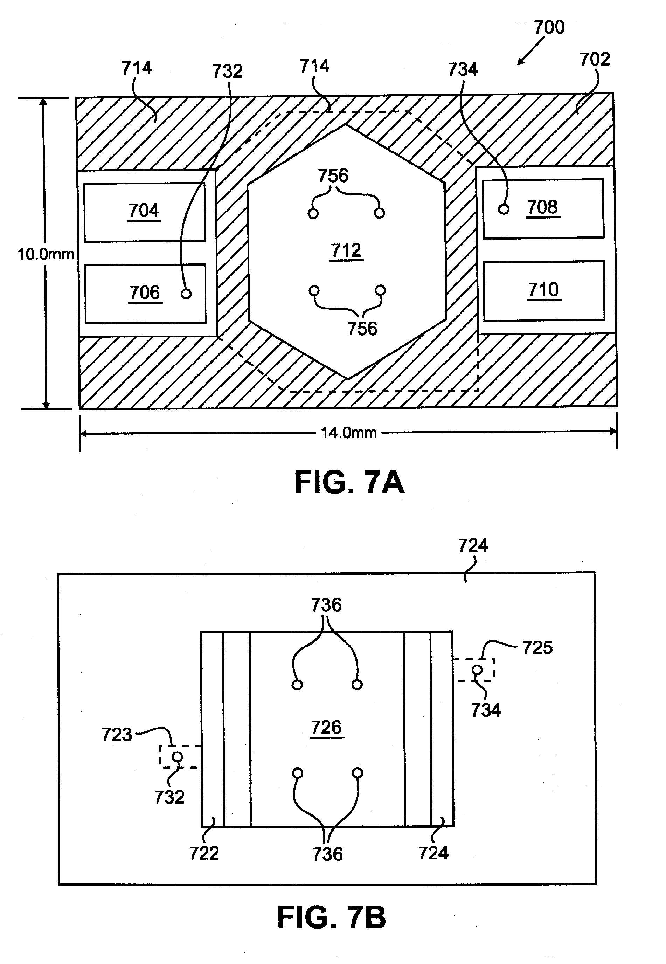

Figs. 7A and 7B show top and bottom views, respectively, of an adapter 700 according to the present invention which supports the migration of a manufacturer from the XR-E lamp of Fig. 1A to the Luxeon® K2 lamp as discussed further below. The physical dimensions of 14.0 mm x 10.0 m for adapter 700 correspond to those shown of a typical solder pad layout for the Luxeon® K2 lamp. Top surface 702 of adapter 700 has conductive pads 704, 706, 708, 710 and 712. A solder mask area 714 is shown cross-hatched. Dashed line 714 is an outline showing where the Luxeon® K2 package is mounted. The electrical wing pinouts of the K2 lamp connect to the conductive pads 704, 706, 708 and 710. As seen in Fig. 7B, the bottom 722 of adapter 700 has the standard electrical and thermal contacts 722, 724 and 726, respectively, for the XR-E lamp with the same dimensions for the contacts as seen in Fig. 1C. The board 700, however, is substantially larger than board 118, for example. As such, so long as a PCB board like board 200 has sufficient landing area for board 700, the board 700 can be used with standard pad 206, for example. In addition to standard electrical contacts 722 and 724, there are extender connections 723 and 725 to connect electrical contacts 722 and 706 and 725 and 708, respectively, by way of vias 732 and 734 filled with solder. Additional vias 736 filled with solder provide thermal connection between the thermal contacts 726 and 712. While Figs. 7A and 7B show an exemplary solder pad and via arrangement, it will be recognized that other arrangements may be devised consistent with the present teachings and the electrical and thermal connections desired for a particular application.

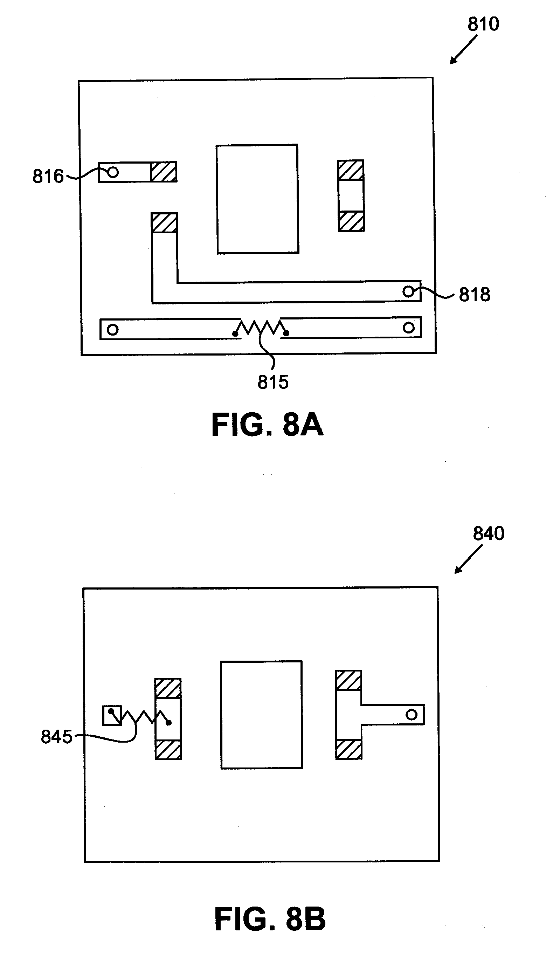

Figs. 8A-8C illustrate further footprint adapters 810, 840 and 870, respectively, in accordance with the present invention. Figs. 8A and 8B show adapters 810 and 840 with current adjusting resistors 815 and 845, respectively for adapting to an LED or LEDs with a different electrical footprint. More specifically, Fig. 8A shows an arrangement for adapting to two LEDs connected in series where each LED has the same resistance as the LED which they are going to replace. In this arrangement, a current balancing resistor 815 is added in parallel with the contacts 816 and 818 for the two series connected LEDs. As was the case in Figs. 3A and 3B, vias connect these contacts to electrical contacts on the bottom of the board.

Fig. 8B shows an arrangement for adapting to two LEDs connected in parallel where again each LED has the same resistance as the LED which are they are going to replace. In this arrangement, a current limiting resistor 845 is added in series as shown in Fig. 8B. It will be recognized that the resistors of 815 and 845 of Figs. 8A and 8B are exemplary of electrical components and circuits more generally if such are needed to adapt with existing circuitry and supplies of current and voltage of a board, such as the board 201 of Fig. 2.

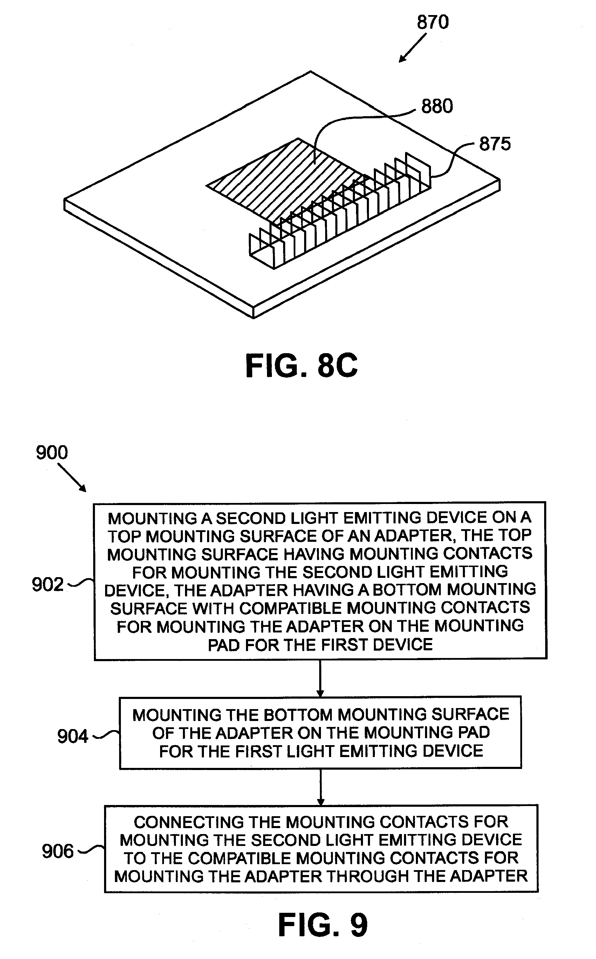

Finally, Fig. 8C illustrates an adapter 870 for an LED having greater thermal dissipation requirements than the LED which it is replacing in which a heat sink 875 is mounted on a portion of a solder pad 880 for the LED.

Fig. 9 illustrates an exemplary process 900 of utilizing a light emitting device footprint adapter according to the present invention to enable a first light emitting device customer to employ a second light emitting device in place of a first light emitting device using an incompatible mounting pad arrangement customized for the first light emitting device. Initially, it is determined that it is desired to employ a second light emitting device in place of a first light emitting device having a different mounting pad arrangement. In step 902, the second light emitting device is mounted on a top mounting surface of an adapter. The top mounting surface of the adapter has mounting contacts for mounting the second light emitting device. A bottom surface of the adapter has mounting contacts compatible with the mount pad arrangement customized for a first light emitting device. In step 904, the bottom surface of the adapter with the second light emitting device mounted on its top surface is mounted on the mounting pad customized for the first light emitting device. In one suitable approach to such mounting, surface mount techniques are employed. In step 906, the first mounting contacts are connected through the adapter on the top surface and the second mounting contacts on the bottom surface of the adapter.

While the present invention has been disclosed in the context of various aspects of presently preferred embodiments, it will be recognized that the invention may be suitably applied to other environments consistent with the claims which follow. By way of example, while the present invention has been disclosed primarily in the context of exemplary LEDs and mounting arrangements, it will be recognized that the present teachings may be readily adapted to other LEDs and mounting arrangements, as well as, other lighting emitting devices, such as other light emitting semiconductor or solid state devices, such as laser diodes, and optoelectronic device chips, such as phototransistors and the like, by way of example. Further, while presently preferred materials and arrangements of exemplary numbers of LEDs are described herein with examples of solder pads and vias, other materials and arrangements may be adapted to particular lighting environments.

## Claims

1. A light emitting device footprint adapter comprising:
a mounting substrate having a top surface with first mounting contacts for mounting a first light emitting device;
the substrate having a bottom surface with mounting contacts for mounting the substrate on a mounting surface having second mounting contacts for a second light emitting device having a different footprint than the first light emitting device; and
connections through the mounting substrate for connecting the first mounting contacts of the top surface with the second mounting contacts of the bottom surface.

2. The light emitting device footprint adapter of claim 1 wherein the first mounting contacts of the top surface comprise electrical contacts and the second mounting contacts of the bottom surface comprise electrical contacts.

3. The light emitting device footprint adapter of claim 1 wherein the first mounting contacts of the top surface comprise thermal contacts and the second mounting contacts of the bottom surface comprise thermal contacts.

4. The light emitting device footprint adapter of claim 2 wherein the first mounting contacts of the top surface further comprise thermal contacts and the second mounting contacts of the bottom surface further comprise thermal contacts.

5. The light emitting device of claim 1 wherein the substrate is a fire resistant (FR) 4 board and the first and second light emitting devices are first and second light emitting diodes (LEDs).

6. The light emitting device of claim 1 wherein the first and second light emitting devices are light emitting diodes having different physical footprints.

7. The light emitting of deice of claim 1 wherein the first and second light emitting devices are light emitting diodes having different electrical footprints.

8. The light emitting device of claim 1 wherein the first and second light emitting devices are light emitting diodes having different thermal footprints.

9. The light emitting device of claim 8 wherein the top surface has an additional heat sink for additional thermal heat dissipation beyond that provided by the bottom surface.

10. A method of utilizing a light emitting device footprint adapter to enable replacement of a first light emitting device having a mounting arrangement with a second light emitting device having an incompatible mounting arrangement, the method comprising:
mounting the second light emitting device on a top mounting surface of an adapter, the top mounting surface having mounting contacts for mounting the second light emitting deice, the adapter having a bottom mounting surface with compatible mounting contacts for mounting the adapter on the mounting pad for the first device; mounting the bottom mounting surface of the adapter on the mounting pad for the first light emitting device; and
connecting the mounting contacts for mounting the second light emitting device to the compatible mounting contacts for mounting the adapter through the adapter.
